# EUROPEAN PATENT APPLICATION

(11) **EP 4 815 275 A1**
(43) Date of publication of application: **30.09.2026**
(21) Application number: 24896558.4
(22) Date of filing: 27.11.2024
(51) Int. Cl.: H02M 1/00

(54) **POWER SUPPLY APPARATUS AND ELECTRONIC DEVICE**

(30) Priority: 28.11.2023 CN 202311613283
(71) Applicant: ZTE CORPORATION, Shenzhen, Guangdong 518057 (CN)
(72) Inventor: OUYANG, Yanhong, Shenzhen, Guangdong 518057 (CN); WANG, Yong, Shenzhen, Guangdong 518057 (CN)
(74) Representative: Ziebig Hengelhaupt Intellectual Property Attorneys Patentanwaltskanzlei PartGmbB
(86) International application number: PCT/CN2024/134783
(87) International publication number: WO 2025/113472

(57) **Abstract**

The present application relates to the technical field of power and electronics, and discloses a power supply apparatus and an electronic device. The power supply apparatus comprises a chip, a first circuit board, and a power supply, a power supply pin of the chip and the power supply being electrically connected by means of a connection part of the first circuit board, a thickness of the connection part being smaller than a thickness of a main body part of the first circuit board, and the power supply being used to supply power to the power supply pin of the chip.

## Description

### CROSS REFERENCE TO RELATED APPLICATIONS

This application claims priority to Chinese Patent Application No. 202311613283.2 filed on November 28, 2023, entitled "Power Supply Apparatus and Electronic Device", the entirety of which is incorporated herein by reference.

### TECHNICAL FIELD

This application relates to the technical field of power and electronics, and in particular to a power supply apparatus and an electronic device.

### BACKGROUD

Currently, an integrated circuit chip and its core current power supply are disposed on the same side of a system printed circuit board (PCB), so as to supply power to the integrated circuit chip. Since the core current power supply supplies power to the integrated circuit chip via the system PCB, the power supply path is relatively long. With increasing demand for chip computing power and higher integration degree of the chip process, the core current continues to increase. If the power supply path is relatively long, with increase of current, the loss caused by supplying power to the integrated circuit chip by the above method also increases significantly.

### SUMMARY

The present application discloses a power supply apparatus and an electronic device.

In a first aspect, embodiments of the present application disclose a power supply apparatus, including a chip, a first circuit board, and a power supply, wherein a power supply pin of the chip and the power supply are electrically connected by means of a connection part of the first circuit board, the thickness of the connection part is smaller than the thickness of a main body part of the first circuit board, and the power supply is used to supply power to the power supply pin of the chip.

In a second aspect, embodiments of the present application disclose an electronic device including the power supply apparatus of the first aspect.

### BRIEF DESCRIPTION OF THE DRAWINGS

FIG. 1 is a schematic structural diagram of a first power supply apparatus disclosed in embodiments of the present application.
FIG. 2 is a schematic structural diagram of a second power supply apparatus disclosed in embodiments of the present application.
FIG. 3 is a schematic structural diagram of a third power supply apparatus disclosed in embodiments of the present application.
FIG. 4 is a schematic structural diagram of a fourth power supply apparatus disclosed in embodiments of the present application.
FIG. 5 is a schematic structural diagram of a fifth power supply apparatus disclosed in embodiments of the present application.
FIG. 6 is a schematic structural diagram of a second circuit board disclosed in embodiments of the present application.
FIG. 7 is a schematic structural diagram of a sixth power supply apparatus disclosed in embodiments of the present application.

### DETAILED DESCRIPTION

Technical solutions in embodiments of the application will be described clearly below with reference to the accompanying drawings in embodiments of the application. Obviously, the embodiments described are part of the embodiments of the application rather than all of the embodiments. All other embodiments obtained by a person skilled in the art based on embodiments in the application fall within the scope of the application.

The terms "first", "second", and the like in the description and in the claims of the application are used to distinguish between similar objects rather than describing a specific order or a sequence. It is to be understood that terms used in such a way may be interchanged where appropriate, whereby embodiments of the application can be implemented in an order other than those illustrated or described herein, the objects distinguished by "first", "second", etc., are generally of one type, and the number of objects is not limited, for example, a first object may refer to one or more first objects. In addition, "and/or" in the description and claims indicates at least one of the objects connected therewith, and the character "/" generally indicates that the objects associated therewith are in an "or" relationship.

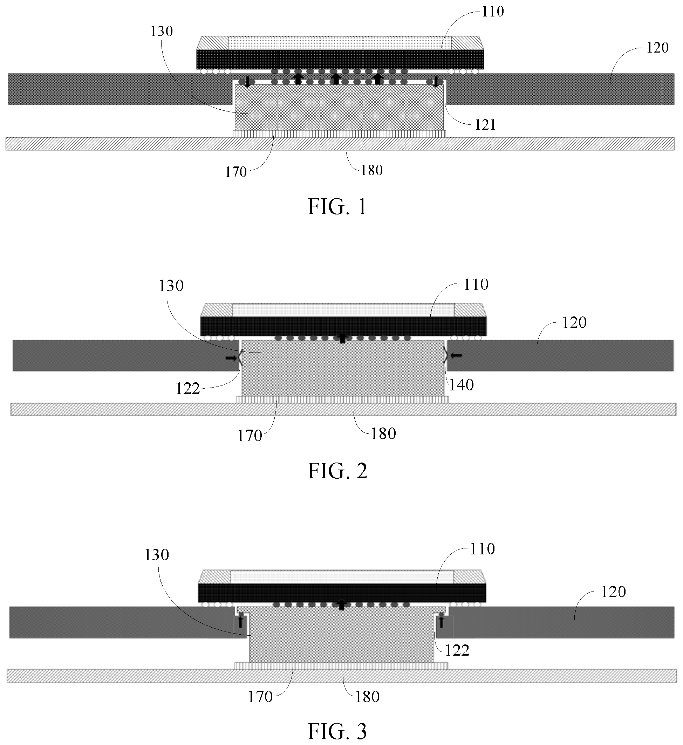

The present application discloses a power supply apparatus and an electronic device, FIG. 1 is a schematic structural diagram of a first power supply apparatus disclosed in embodiments of the present application.

As shown in FIG. 1, the power supply apparatus disclosed in embodiments of the present application includes a chip 110, a first circuit board 120, and a power supply 130, wherein a power supply pin of the chip 110 and the power supply 130 are electrically connected by means of a connection part of the first circuit board 120, the thickness of the connection part is smaller than the thickness of a main body part of the first circuit board 120, and the power supply is 130 used to supply power to the power supply pin of the chip 110.

In the present application, as shown in FIG. 1, the first circuit board 120 is used to supply input power to the power supply 130. The power supply is 130 used to supply power to the power supply pin of the chip 110. The chip 110, the first circuit board 120, and the power supply 130 are arranged in order, and the position of the connection part of the first circuit board 120 corresponds to that of the power supply pin of the chip 110 and that of the power supply 130.

Since the power supply pin of the chip 110 and the power supply 130 are electrically connected by means of the connection part of the first circuit board 120, and the thickness of the connection part of the first circuit board 120 is smaller than the thickness of the main body part of the first circuit board 120, the technical solution disclosed in the embodiments of the present application can be used to effectively shorten the power supply path, reduce the loss caused by supplying power to the chip, reduce the system heat consumption and line parasitic parameters, and improve power supply performance.

It should be noted that the main body part of the first circuit board is an area, other than the connection part, on the first circuit board. The first circuit board may be a system PCB.

Embodiments of the present application provide a power supply apparatus, the power supply apparatus includes a chip, a first circuit board, and a power supply, the power supply pin of the chip and the power supply are electrically connected by means of a connection part of the first circuit board, the thickness of the connection part of the first circuit board is smaller than the thickness of the main body part of the first circuit board, the power supply is used to supply power to the power supply pin of the chip, which can effectively shorten the power supply path, reduce the loss caused by supplying power to the chip, and reduce system heat consumption.

In one implementation, as shown in FIG. 1, the connection part may include a recess 121, and at least part of the power supply 130 may be disposed within the recess 121.

In embodiments of the present application, the recess 121 is formed in one side of the first circuit board 120, a pad is provided on the bottom of the recess 121 and at a position, corresponding to the bottom of the recess 121, on the other side of the first circuit board 120, at least part of the power supply 130 extends into the opening of the recess 121 and is disposed within the recess 121, the power supply pin of the chip 110 and the power supply 130 are electrically connected by the bottom of the recess 121 formed in the first circuit board 120, that is, the power supply 130 supplies power to the power supply pin of the chip by means of the bottom of the recess 121, which can shorten the power supply path, reduce the loss caused by supplying power to the chip, and reduce system heat consumption. In this embodiment, as shown in FIG. 1, the input power can be supplied to the power supply 130 by means of the bottom of the recess 121 formed in the first circuit board 120.

With the solution disclosed in the embodiment of the present application, since at least part of the power supply 130 is disposed within the recess 121, the available height of the power supply 130 is increased, and by using a larger-sized power supply or lowering the switching frequency, the overall conversion efficiency of the power supply can be improved, heat consumption can be reduced, and the difficulty of system heat dissipation can be lowered. In addition, by controlling the thickness tolerance of the position, where the recess is arranged, of the first circuit board 120, the requirement for height tolerance of the power supply 130 can be reduced, thereby lowering the design and processing difficulty of the power supply 130.

The above power supply apparatus has a simple production process, and the maintainability of the power supply 130 in later stages is high.

In another implementation, as shown in FIG. 2, the connection part may include a through hole 122, and at least part of the power supply 130 may be disposed within the through hole 122.

In this case, as shown in FIG. 2, part of the pins of the chip 110 are electrically connected to the first circuit board, and the power supply pin of the chip is directly electrically connected to the power supply 130, thereby shortening the power supply path, reducing the loss caused by supplying power to the chip, and reducing system heat consumption.

Moreover, with the solution disclosed in the embodiment of the present application, since at least part of the power supply 130 is disposed within the through hole 122, the available height of the power supply 130 is increased, and by using a larger-sized power supply, the overall efficiency of the power supply can be improved, and the design difficulty of the power supply can be lowered. In addition, the height of the power supply 130 of the power supply apparatus provided in this embodiment is not affected by the thickness tolerance of the first circuit board 120, which can further lower the design and processing difficulty of the power supply 130.

Furthermore, the side wall of the through hole 122 formed in the first circuit board 120 may be metalized, for example, the side wall of the through hole 122 formed in the first circuit board 120 may be copper-plated, and then the power supply 130 may be electrically connected to the side wall of the through hole 122, and the first circuit board 120 supplies input power to the power supply 130 by means of the side wall of the through hole 122.

In the above embodiment, the force directions of the electrical connection point between the chip 110 and the power supply 130, the electrical connection point between the chip 110 and the first circuit board 120, and the electrical connection point between the power supply 130 and the first circuit board 120 are all downwards, which can improve the reliability of the electrical connection points in terms of structure.

In one implementation, as shown in FIG. 3, the through hole 122 may include a first limiting part, and the power supply 130 may include a second limiting part, and the first limiting part and the second limiting part are in limiting fit.

For example, the side wall of the through hole 122 may be partially stepped as the first limiting part, or the side wall of the through hole 122 may be entirely stepped as the first limiting part, as shown in FIG. 3, the side wall of the power supply 130 is provided with a second limiting part corresponding to the first limiting part of the through hole 122, limiting fit between the first limiting part and the second limiting part can position the power supply 130, facilitate soldering, reduce the number of reflow soldering cycles, reduce constraints on component selection and processes, and indirectly improve board reliability. It should be noted that pads and solder balls connected to the second limiting part may be disposed on the first limiting part.

In addition, the first circuit board 120 supplies input power to the power supply 130 by means of the first limiting part, and supplying input power to the power supply 130 in this way can reduce occupied resources of the first circuit board 120 and reduce interference in high-speed signal lines of the chip.

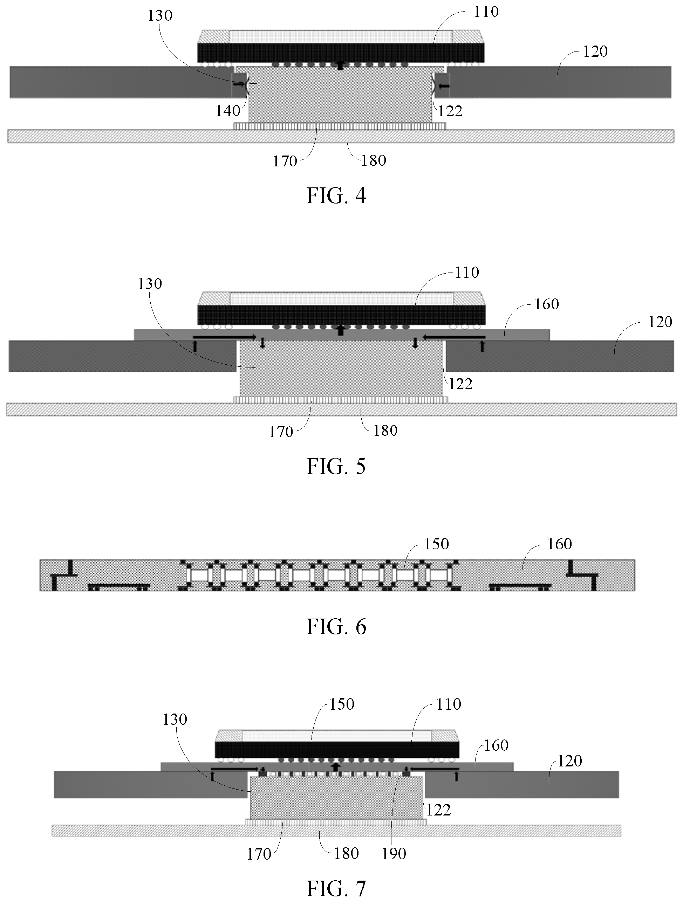

In the embodiment of the present application, as shown in FIG. 2 and FIG. 4, the power supply 130 and the side wall of the through hole 122 may be electrically connected by means of a conductive member 140, and the first circuit board 120 supplies input power to the power supply 130 by means of the side wall of the through hole 122. For example, the conductive member 140 may include an elastic member or a plug-in member, to improve the stability and reliability of connection between the power supply 130 and the side wall of the through hole 122. Furthermore, a soldering material such as solder may be added to the connection position between the side wall of the through hole 122 and the power supply 130, so as to further improve the stability and reliability of the connection between the power supply 130 and the side wall of the through hole 122.

In one possible implementation, the power supply apparatus may further include a filter capacitor 150, the filter capacitor 150 may be disposed, at a position close to the power supply pin of the chip 110, within the power supply 130. By disposing the filter capacitor 150 at a position, which is close to the power supply pin of the chip 110, within the power supply 130, the filtering performance can be improved, and thus, the power supply quality is improved.

It should be noted that the positive electrode of the power supply 130 is electrically connected to the positive electrode of the power supply pin of the chip 110 at a first connection point, and the negative electrode of the power supply 130 is electrically connected to the negative electrode of the power supply pin of the chip 110 at a second connection point, the positive electrode of the filter capacitor 150 is electrically connected to the first connection point, and the negative electrode of the filter capacitor 150 is electrically connected to the second connection point.

In another possible implementation, the power supply apparatus may further include a filter capacitor 150, the filter capacitor 150 may be disposed between the power supply 130 and the power supply pin of the chip 110. By disposing the filter capacitor 150 between the power supply 130 and the power supply pin of the chip 110, the filtering performance can be improved, and thus, the power supply quality is improved.

It should be noted that the way in which the filter capacitor 150 is connected to the power supply 130 and the chip 110 is the same as that described above, which will not be repeated here.

In one implementation, when the connection part includes a through hole 122 and at least part of the power supply is disposed within the through hole 122, as shown in FIG. 5, the aforementioned power supply apparatus may further include a second circuit board 160, the second circuit board 160 is disposed between the chip 110 and the first circuit board 120, and the second circuit board 160 is electrically connected to the power supply pin of the chip 110, the first circuit board 120, and the power supply 130.

In this case, as shown in FIG. 5, the power supply 130 supplies power to the power supply pin of the chip 110 by means of the second circuit board 160, and the first circuit board 120 supplies input power to the power supply 130 by means of the second circuit board 160. By adopting the solution disclosed in this embodiment, since the power supply 130 supplies power to the power supply pin of the chip 110 by the second circuit board 160, one-to-one correspondence is not needed between the pins of the power supply 130 and the pins of the chip , one power supply can supply power to different chips. When one power supply is used to supply power to different chips, only the second circuit board 160 needs to be adjusted accordingly. By adopting the power supply apparatus disclosed in this embodiment, the power supply can be multiplexed, and the cost can be reduced.

In addition, the current path from the power supply 130 to the chip 110 on the second circuit board 160 may be designed in the form of dense vias, so as to shorten the power supply path and reduce parasitic parameters.

It should be noted that in practical applications, the material of the second circuit board may be selected as required, while ensuring rigidity, the thickness of the second circuit board may be reduced to shorten the power supply path and reduce the loss and parasitic parameters caused by supplying power to the chip.

In one implementation, as shown in FIG. 6, the power supply apparatus may further include a filter capacitor 150, and the filter capacitor 150 may be disposed inside the second circuit board 160. For example, by processes such as embedding or surface mounting followed by encapsulation, the filter capacitor at the output end of the power supply 130 may be disposed inside the second circuit board 160, which can reduce the distance between the filter capacitor 150 and the chip 110, improve filtering performance, improve power supply quality, and saving occupied space. In addition, the filter capacitor in the present application may be a ceramic filter capacitor.

It should be noted that the way in which the filter capacitor 150 is connected to the power supply 130 and the chip 110 is the same as that described above, which will not be repeated here.

Furthermore, the present application does not limit the number of layers of the second circuit board 160 or the number of layers embedded in the second circuit board 160 of devices, and lines may be arranged according to actual needs to implement connections between layers.

In another implementation, as shown in FIG. 7, the power supply 130 and the second circuit board 160 are electrically connected by means of a connecting member 190, and the filter capacitor 150 is disposed between the power supply 130 and the second circuit board 160 to improve the filtering performance, thereby improving power supply quality. For example, the connecting member 190 may include but is not limited to a copper block or pin headers, and the filter capacitor 150 may be disposed at the power supply end or at the second circuit board end.

It should be noted that the way in which the filter capacitor 150 is connected to the power supply 130 and the chip 110 is the same as that described above, which will not be repeated here.

Furthermore, in addition to the filter capacitor 150, other components may be soldered at positions, corresponding to the through hole 122 formed in the first circuit board 120, on the second circuit board 160 according to actual needs.

In the embodiment of the present application, as shown in FIG. 1, the power supply apparatus may further include a thermal conductive medium 170 and a backing plate 180, the power supply 130 and the backing plate 180 are connected by means of the thermal conductive medium 170. That is, heat from the power supply 130 can be conducted to the backing plate 180 by means of the thermal conductive medium 170 for dissipation. When adopting this heat dissipation method, the power supply 130 may be correspondingly designed in a bottom heat dissipation way. For example, the backing plate 180 may be a metal structure. It should be noted that the surface, in contact with the thermal conductive medium 170, of the power supply 130 is the bottom of the power supply 130.

In this case, the height of the power supply 130 may be determined based on the connection part of the first circuit board 120 and the backing plate 180, and the thermal conductive medium 170 may also absorb part of the assembly tolerance to reduce the requirement for tolerance of the power supply 130.

In addition, the power supply apparatus may further include a heat dissipation device for the chip 110, and the heat dissipation device for the chip 110 may be disposed on the first circuit board 120 or the backing plate 180.

It should be noted that the above power supply apparatus may be applied to occasions of integrated circuit chip power supply, especially occasions of low-voltage, high-current integrated circuit chip power supply.

The present application further discloses an electronic device including the power supply apparatus described above.

For example, the electronic device may include but is not limited to a wireless server, a wired router, a switch, etc.

The above embodiments of the present application focus on description of differences among various embodiments, different optimized features from various embodiments can be combined to form more preferred embodiments so long as they are not contradictory, this will not be repeated here for the purpose of clarity.

The above descriptions are merely embodiments of the present application and are not intended to limit the present application. Those skilled in the art will appreciate that, various modification and alteration can be made to the present application. Any modification, equivalent replacement, improvement, etc., that is made within the spirit and principle of the present application should be included within the scope of the claims of the present application.

## Claims

1. A power supply apparatus, comprising a chip (110), a first circuit board (120) and a power supply (130), wherein
a power supply pin of the chip (110) and the power supply (130) are electrically connected by means of a connection part of the first circuit board (120), a thickness of the connection part is smaller than a thickness of a main body part of the first circuit board (120), and the power supply (130) is used to supply power to the power supply pin of the chip (110).

2. The power supply apparatus according to claim 1, wherein the connection part comprises a recess (121), and at least part of the power supply (130) is disposed within the recess (121).

3. The power supply apparatus according to claim 1, wherein the connection part comprises a through hole (122), and at least part of the power supply (130) is disposed within the through hole (122).

4. The power supply apparatus according to claim 3, wherein the through hole (122) comprises a first limiting part, the power supply (130) comprises a second limiting part, and the first limiting part and the second limiting part are in limiting fit.

5. The power supply apparatus according to claim 3, wherein the power supply (130) and a side wall of the through hole (122) are electrically connected by means of a conductive member (140).

6. The power supply apparatus according to claim 5, wherein the conductive member (140) comprises an elastic member or a plug-in member.

7. The power supply apparatus according to any one of claims 1 to 6, further comprising a filter capacitor (150), wherein the filter capacitor (150) is disposed at a position, close to the power supply pin of the chip (110), in the power supply (130).

8. The power supply apparatus according to any one of claims 1 to 6, further comprising a filter capacitor (150), wherein the filter capacitor (150) is disposed between the power supply (130) and the power supply pin of the chip (110).

9. The power supply apparatus according to claim 3, further comprising a second circuit board (160), wherein the second circuit board (160) is disposed between the chip (110) and the first circuit board (120), and the second circuit board (160) is electrically connected to the power supply pin of the chip (110), the first circuit board (120), and the power supply (130).

10. The power supply apparatus according to claim 9, further comprising a filter capacitor (150), wherein the filter capacitor (150) is disposed inside the second circuit board (160).

11. The power supply apparatus according to claim 1, further comprising a thermal conductive medium (170) and a backing plate (180), wherein the power supply (130) and the backing plate (180) are connected by means of the thermal conductive medium (170).

12. An electronic device, comprising the power supply apparatus according to any one of claims 1 to 11.
